# EUROPEAN PATENT SPECIFICATION

(11) **EP 1 032 031 B1**
(45) Date of publication and mention of the grant of the patent: **10.10.2007**
(21) Application number: 99830532.0
(22) Date of filing: 26.08.1999
(51) Int. Cl.: H01L 21/762, H01L 27/06, H01L 21/761

(54) **Electronic power device monolithically integrated on a semiconductor and comprising edge protection structures having a limited planar dimension and its manufacturing method**
Monolithisch auf einem Halbleiter integriertes elektronisches Leistungsbauelement mit Strukturen zum Schutz der Ecken mit begrenzter Flächengrösse und zugehöriges Herstellungsverfahren
Dispositif électronique de puissance intégrée monolithiquement sur un semi-conducteur et comprenant des structures de protection des bords avec une dimension planaire limitée et méthode de fabrication associée

(30) Priority: 23.10.1998 EP 98830638
(43) Date of publication of application: 30.08.2000
(73) Proprietor: STMicroelectronics S.r.l., 20041 Agrate Brianza (Milano) (IT)
(72) Inventor: Leonardi, Salvatore, S.M. La Stella-Aci S. Antonio (CT) (IT)
(74) Representative: Botti, Mario

(56) References cited:
- EP-A- 0 509 183
- EP-A- 0 735 580
- US-A- 5 308 786
- US-A- 5 374 583
- US-A- 5 650 354
- PATENT ABSTRACTS OF JAPAN vol. 007, no. 284 (E-217), 17 December 1983 (1983-12-17) -& JP 58 161342 A (DAINI SEIKOSHA KK), 24 September 1983 (1983-09-24)
- PATENT ABSTRACTS OF JAPAN vol. 008, no. 231 (E-274), 24 October 1984 (1984-10-24) -& JP 59 112633 A (TOSHIBA KK), 29 June 1984 (1984-06-29)

## Description

### Field of the Invention

This invention relates to an electronic power device monolithically integrated on a semiconductor substrate and having edge protection structures of limited planar size.

The invention specifically relates to a monolithic semiconductor device wherein P/N junctions are capable of sustaining high operating voltages, a base-collector junction of an NPN bipolar transistor being exemplary of these.

The invention further relates to a method of manufacturing the protection structure of limited planar size.

The invention relates, particularly but not exclusively, to a structure of limited planar size which functions as an edge structure for a VIPOWER type of power device, and the description to follow will make reference to this field of application for convenience of illustration only.

### Prior Art

As is known, in semiconductor electronic devices, most of the P/N junctions fabricated with planar technology comprise basically a first semiconductor region having a first type of conductivity and being diffused into a second semiconductor region with the opposite type of conductivity from the first. An insulating layer of silicon oxide is laid over both regions, and metal contacts are then formed to establish an electric connection to the two semiconductor regions.

A depleted region is associated with the P/N junction. This depleted region can be regarded as formed of two regions: a first region along a planar region of the junction, and the second region at the edges of the planar region.

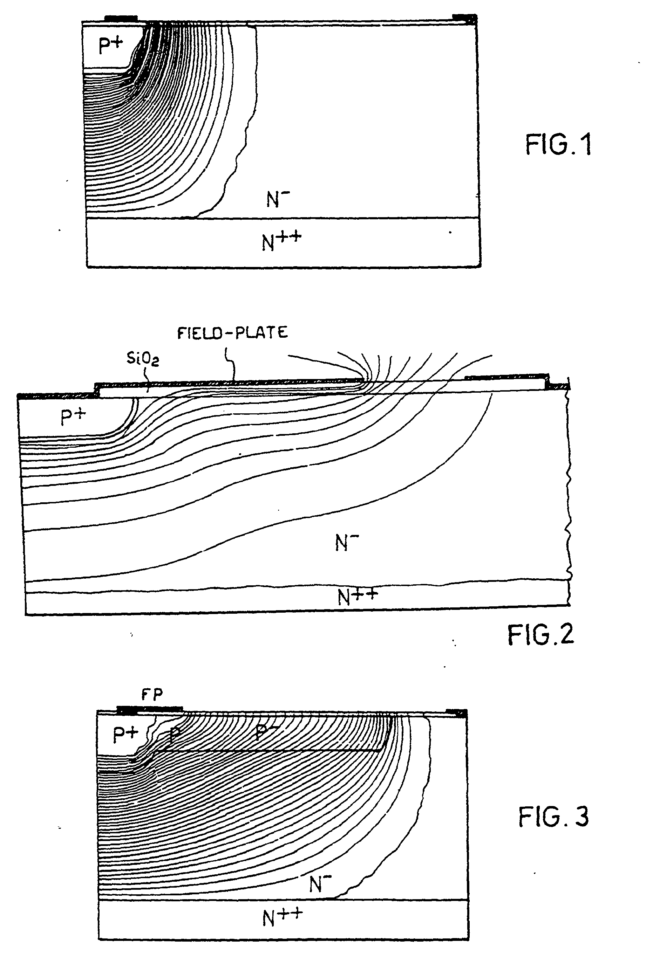

In the planar region, the equipotential lines lie parallel to the junction, the peak electric field is centered at the junction, and the field breakdown occurs upon the field reaching its critical value. Referring to Figure 1, the equipotential lines curve and are more crowded together at the junction edges than in the planar region, due to the junction depth being finite. Consequently, the electric field at the edge region is increased; stronger electric fields being associated with smaller radii of curvature.

The breakdown voltage of a finite P/N junction is usually lower than that associated with the corresponding planar junction because of the electric field being much stronger at the edge region. The breakdown voltage ratio between the edge and the planar portion is, therefore, smaller than unity. Thus, an ability to define and implement technical solutions which can limit the drop in the critical electric field at the edge regions of the structure acquires special importance.

A first prior approach to filling this demand provided for the use of metal field plates located proximate to the structure edge. The field plates are not in direct contact with the silicon surface, but rest on the previously deposited, or grown, layer of silicon oxide.

Referring to Figure 2, a major feature of metal layers immersed in an electric field is that they set at a single potential throughout their spread. Accordingly, the metal field plates, if suitably dimensioned, will force the depleted region to span a large area, thus preventing crowding of the equipotential lines.

While being in several ways advantageous, this first of the prior approaches has certain drawbacks. For devices which are to endure high operating voltages, the surface electric field still remains high, and even if below the critical value, may be sensitive to the amount of surface charge brought about by the presence of moving charges or fixed charges at the oxide/silicon interface, introduced during the process steps for manufacturing the power devices.

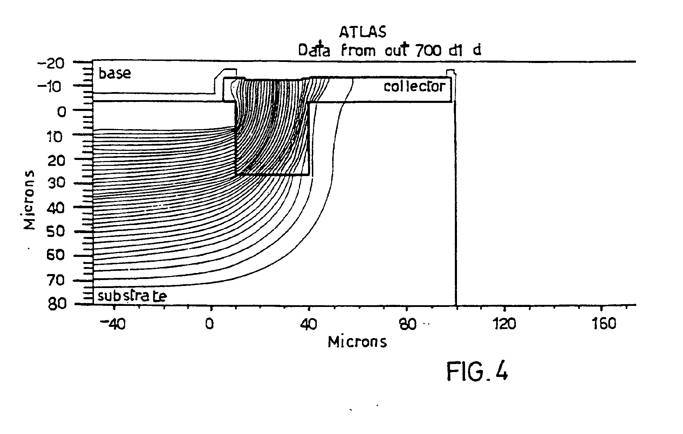

A second prior approach, disclosed in GB-A-216597, proposes high-resistivity rings placed in electric contact with the main junction to be protected. Referring to Figure 3, this approach, by forcing the depleted region to span broader regions, also results in thinned equipotential lines and, hence, a weaker surface electric field.

Although achieving its objective, not even this prior approach is devoid of shortcomings. The presence of high-resistivity rings gives rise to peaks in the electric field near the interface between any two rings and at the edge of the outermost ring. Furthermore, the ring structure increases the space requirements of the device. In fact, a reduction in the surface electric field is made dependent on the number and the width of the high-resistivity rings. Accordingly, devices operated in a high voltage range require edge structures of large planar size.

Also known from the European Patent Application No. EP 0 509 183 to Consorzio per la Ricerca sulla Microelettronica nel Mezzogiorno is a monolithic semiconductor device comprising a power or HV portion and a signal or LV portion separated by means of a trench, which is an interface isolation structure being of a large planar size.

Moreover, the US Patents Nos. 5,374,583 and 5,308,786 to Lur et al. (United Microelectronics Corporation) describe methods for realising dielectric regions by oxidation in place of the known LOCOS technique. In order to obtain properly working dielectric regions, which separates superficially the integration well of the single circuit components, the bottom of them is also enriched of dopants so as to avoid any triggering of parasitic channels or elements.

The technical problem underlying this invention is to provide a device for high-voltage operation with protection structures effective to combine proper performance of the device through its operational range with reduced planar size, thereby overcoming the drawbacks of devices according to the prior art.

### Summary of the Invention

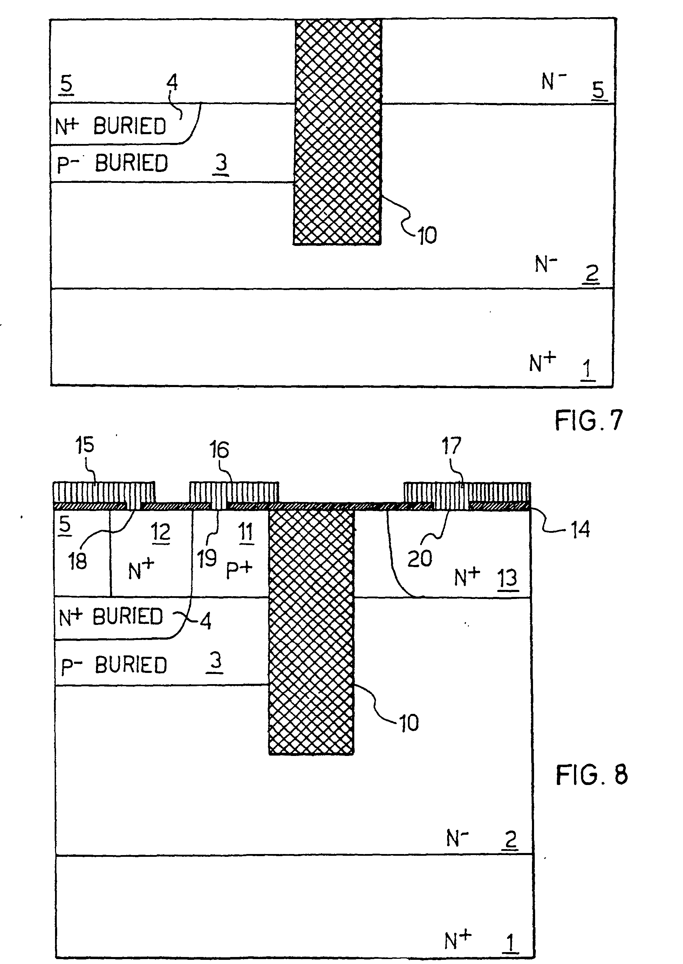

The concept behind the present invention is that of providing an electronic power device with a protective structure of limited planar size by using trench structures of substantial thickness formed within the silicon substrate and completely filled with dielectric material. Referring to Figure 7, the presence of a trench in direct contact with the P/N junction is effective, in a reverse bias situation, to cause the equipotential lines to crowd together within the trench-filling dielectric material.

Since the critical (breakdown) electric field for the dielectric material, e.g. silicon oxide, is approximately 600V/µm, whereas the critical electric field for silicon is approximately 20V/µm, the oxide-filled trench structure can be made much smaller than edge structures according to the prior art.

As an example, a conventional edge structure for a power device which is to sustain a reverse bias voltage of 700V would account for approximately 40% of the device total area, whereas an edge structure according to this invention would be a planar size equal to about 10-15% of the device total area.

Based on this concept, the technical problem is solved by an electronic device as previously indicated and defined in the characterizing portion of Claim 1, and by a method of manufacturing an electronic device as defined in the characterizing portion of claim 8. The features and advantages of the electronic device according to the invention will become more clearly apparent from the following description of an embodiment thereof, given by way of non-limitative example with reference to the accompanying drawings.

### Brief Description of the Drawings

In the drawings:
Figure 1 illustrates in schematic form a simulation of a planar P⁺/N⁻ junction (as viewed across a section thereof) in a condition of reverse bias, showing the spatial distribution of the equipotential lines;
Figure 2 illustrates in schematic form a simulation of a planar P⁺/N⁻ junction in a condition of reverse bias and in the presence of a metal field plate;
Figure 3 illustrates in schematic form a simulation of a planar P⁺/N⁻ junction in a condition of reverse bias and in the presence of a high-resistivity ring (denoted by P⁻) ;
Figure 4 illustrates in schematic form a simulation of a planar P⁺/N⁻ junction in a condition of reverse bias and in the presence of an edge structure consisting of a silicon trench filled with silicon oxide to a substantial thickness, according to the invention;
Figures 5 to 8 are partial cross-sectional views of a VIPOWER device at various stages of the process according to the invention;
Figures 9 and 10 illustrate graphically the dependence of the junction breakdown voltage on the varying depth and width of the trench structure.

### Detailed Description

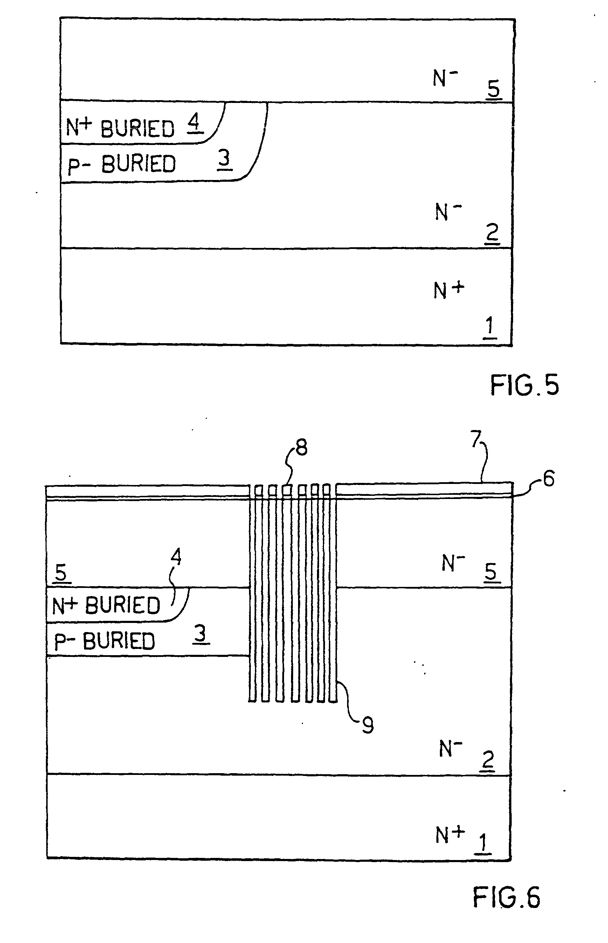

Referring in particular to Figures 5, 6, 7 and 8, a method according to the invention for manufacturing -- starting from an N⁺ semiconductor substrate -- a monolithically integrated, electronic power device of the VIPOWER type provided with a protective structure of substantial thickness and limited planar size, will now be described.

The process steps and the structures described hereinafter are not exhaustive of a process flow for manufacturing semiconductor power devices. The present invention can be implemented along with power device manufacturing techniques currently in use, and only such currently used process steps will be considered as are necessary to a proper understanding of this invention.

Figures showing cross-sectional views of a VIPOWER device during its fabrication are not drawn to scale, but rather to highlight major features of the invention.

An epitaxial layer 2 of the N⁻ type is grown over the surface of an N⁺ substrate 1. A region 3 of the P type, buried relative to the final surface of the device, is diffused into the epitaxial layer 2. Again by diffusion, a region 4 of the N⁺ type is formed within the region 3 which will also be buried relative to the final surface of the device.

A second epitaxial layer 5 of the N⁻ type is grown over the surface of the epitaxial layer 2. The substrate 1 constitutes, with the epitaxial layer 2 and the epitaxial layer 5, the bulk region of the transistor.

A thin oxide layer 6 is formed over the surface of the epitaxial layer, e.g. to a thickness of a few hundred Ångstrom. On top of this oxide layer 6, there may be deposited a layer 7 of a dielectric material, specifically silicon nitride, e.g. to a thickness of about one thousand Ångstrom.

Advantageously in this invention, a thick edge protection structure is provided having a silicon oxide trench of suitable dimensions to sustain operating voltages of up to 700V. In this case, the trench is 30µm deep and 30µm wide.

A plurality of small equispaced trenches 8 are formed in the layers 5 and 2, within the region where this protection structure is to be provided, as shown in Figure 6, using conventional photolithographic techniques and successive etching processes through the layers 7 and 6, the epitaxial layer 5, and a portion of the epitaxial layer 2.

The small equispaced trenches 8 are parallel to one another. The regions of the small equispaced trenches 8 bound a plurality of walls 9 of semiconductor material.

These walls 9 extend parallel to the small equispaced trenches 8 and exhibit an essentially comb-like profile when viewed in a vertical cross-section through at least two walls 9.

The nitride layer 7 is then removed from the structure, and the semiconductor is subjected to a thermal treatment in an oxidising medium. The oxidising thermal treatment should be adequate to turn all the silicon walls that delimit the trenches into oxide.

By suitable dimensioning of the small equispaced trenches 8, a single trench 10 is obtained which is filled up by oxide as shown in Figure 8.

Alternatively, where the oxidising process yields no trench completely filled with oxide, a dielectric layer with planarizing properties can be deposited to fill the vacant trench regions.

In a preferred embodiment of the process according to the invention, these small equispaced trenches 8 are arranged to interrupt the buried region 3 of the P type, thereby providing a junction of the "mesa" type. In this way, the finished trench 10 will suppress the spiking effect.

It should be noted that this advantageous embodiment can only be implemented with a finished trench 10 which has been obtained from the plural small equispaced trenches 8 according to this invention, and is impracticable with a single trench obtained by filling in as in the prior art.

An anisotropic planarizing etch-back is then carried out which may be followed by a planarizing process, e.g. of a chemio-mechanical nature.

Advantageously in this method, the top surface of the oxide-filled trench 10 and the surface of the layer 5 are coplanar, thus allowing the process flow for forming the power device to be carried out conventionally.

A region 11 of the P⁺ type is formed by diffusion at the left-hand side of the oxide-filled trench which constitutes, in combination with the region 3, the base region of the NPN transistor. Furthermore, the region 11 locally improves the transistor base region such that the electric field can be reduced locally.

It should be noted that this region 11 need not be in contact with the trench 10 for the device to perform correctly.

Furthermore, this region 11 is not even strictly necessary; it has been introduced to establish a contact to the buried region P, and may be omitted where this contact is not required.

Two regions of the N⁺ type are then formed by diffusion in the epitaxial layer 5, namely a region 12 and a region 13. The region 12 constitutes the emitter of the NPN transistor, and the region 13 constitutes the channel stopper.

The whole surface area is then covered with an insulating oxide 14, wherewithin contact areas are formed to enable the metal strips 15, 16, 17 to contact the regions 18, 19, 20, respectively.

Advantageously in this invention, the metallization layer 16 will not cover the trench 10, since it is not required to function as a field plate for straightening the field lines inside the junction.

Likewise, the metallization layer 17 extends to a distance short of the trench 10 which is dependent on the voltage sustaining specifications for the device.

It should be noted that the effectiveness of the trench structures according to the invention is only of importance where the depth of such structures exceeds the depth of the junction to be protected.

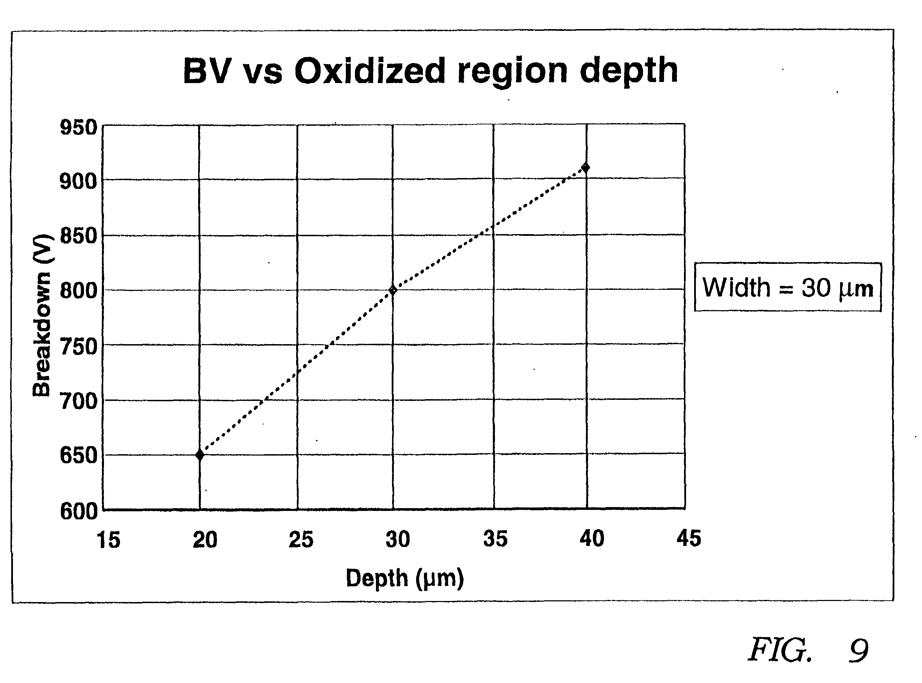

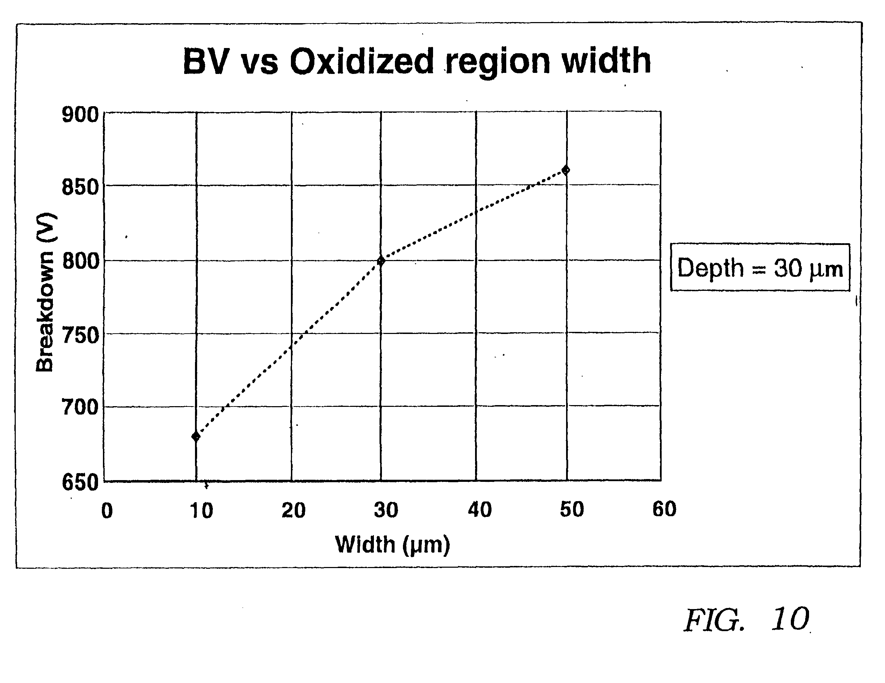

In particular, Figures 9 and 10 illustrate graphically the dependence of the breakdown voltage of the junction on the varying depth (Figure 9) and breadth (Figure 10) of the trench structure.

The Applicant has plotted the graphs in Figures 9 and 10 by subjecting to simulation substrates with the following specifications:
- junction "curvature" voltage in the 600V range;
- breakdown voltage of the "planar" junction in the 1150V range.

It can be readily seen from these graphs that, as the size of the trench structure employed increases, the breakdown voltage, and hence the efficiency of the edge structure, also increases. In this respect, creating trenches with some particular shape, from a plurality of small equispaced trenches having different lengths, is not recommended.

## Claims

1. An electronic power device integrated monolithically in a semiconductor substrate (1), including at least one power region, itself having at least one P/N junction provided therein which comprises a first semiconductor region (3) with a first type of conductivity extending into said semiconductor substrata (1) from a device top surface and being diffused into a second semiconductor region (2) with a second type of conductivity being opposite with respect to the first type of conductivity, said device further including at least one edge protection structure of substantial thickness and limited planar size incorporating at least one trench (10) filled with dielectric material, **characterized in that** said at least one trench (10) is placed adjacent to said power region and in direct contact with said P/N junction and it has a depth equal Lo or greater than the depth of said P/N junction, said at least one trench (10) being formed, starting from a plurality of small trenches (8) realised in said semiconductor substrate (1) with predetermined lengths equal to said depth of said at least one trench (10) and bounded by a plurality of corresponding walls (9) of semiconductor material having predetermined widths, by oxidising said semiconductor material by means of a thermal process in order to oxidise said walls (9) and produce said at least one trench (10) being effective, in a reverse bias situation, to cause equipotential lines of the electric field inside said device to crowd together within said at least one trench (10).

2. An electronic device according to Claim 1, **characterized in that** small trenches (8) are equispaced and parallel to each other.

3. An electronic device according to Claim 1,
**characterized in that** at least one epitaxial semiconductive layer (2) with said first type of conductivity is deposited onto the semiconductor substrate (1), and that said at least one trench (10) extends deeper than the epitaxial layer (2), from the device top surface.

4. An electronic device according to Claim 1, wherein the dielectric in said trench (10) is silicon oxide.

5. An electronic device according to Claim. 1, **characterized in that** it includes a metallization layer (16) covering the F side of the P/N junction but not said at least one trench (10).

6. An electronic device according to Claim 1, **characterized in that** it includes a metallization layer (17) covering the N side of the P/N junction but not said at least one trench (10).

7. An electronic device according to Claim 1, **characterized in that** the ratio of said lengths of said small trenches (8) to said widths of said walls (9) is such that said small trenches (8) exit said oxidising thermal process completely filled with oxide.

8. A method of manufacturing an electronic power device integrated monolithically in a semiconductor substrate (1), including at least one power region, itself having at least one P/N junction provided therein which comprises a first semiconductor region (3) with a first type of conductivity extending into said semiconductor substrate (1) from a top device surface and being diffused into a second semiconductor region (2) with a second type of conductivity being opposite with respect to the first type of conductivity, **characterized in that** at least one trench (10) filled with dielectric material, provided as an edge protection structure of said P/N junction, is obtained hy the following steps:
forming a plurality of small trenches (8) in said semiconductor substrate (1) which have predetermined lengths equal to or greater than the depth of said P/N junction and are bounded by a plurality of corresponding walls (9) of semiconductor material having predetermined widths;
oxidising said semiconductor material by means of a thermal process in order to oxidise said walls (9) and produce said at least one trench (10) adjacent to said power region and in direct contact with said P/N junction, said at least one trench (10) being effective, in a reverse bias situation, to cause equipotential lines of the electric field inside said device to crowd together within said at least one trench (10).

9. A method of manufacturing an electronic device according to Claim 7, **characterized in that** said step of forming a plurality of small trenches (8) forms small trenches (8) which are equispaced and parallel to each other

10. A method of manufacturing an electronic device according to Claim 8, **characterized in that** the ratio of said lengths of said small trenches (8) to said widths of said walls (9) is such that said small trenches (8) exit said oxidising thermal process completely filled with oxide.

11. A method of manufacturing an electronic device according to Claim 8, **characterized in that** it further comprises a step of depositing a dielectric layer with planarizing properties to fill regions of said small trenches (8).

12. A method of manufacturing an electronic device according to Claim 8, **characterized in that** it further includes a planarizing process.

13. A method of manufacturing an electronic device according to Claim 8, **characterized in that** said step of forming said plurality of small trenches (8) interrupts said second semiconductor region (3), thereby providing a junction of the so-called mesa type.

## Patentansprüche

1. In ein Halbleitersubstrat (1) monolithisch integriertes elektronisches Leistungsbauelement mit mindestens einem Leistungsbereich, in dem wiederum mindestens ein P/N-Übergang vorgesehen ist, der einen ersten Halbleiterbereich (3) eines ersten Leitfähigkeitstyps aufweist, der sich von einer oberen Oberfläche des Bauelements in das Halbleitersubstrat (1) hinein erstreckt und in einen zweiten Halbleiterbereich (2) eines zweiten Leitfähigkeitstyps entgegengesetzt zu dem ersten Leitfähigkeitstyp eindiffundiert ist, wobei das Bauelement ferner wenigstens eine Randschutzstruktur mit beträchtlicher Dicke und begrenzter planarer Größe mit mindestens einem darin enthaltenen Graben (10) aufweist, der mit dielektrischem Material gefüllt ist,
**dadurch gekennzeichnet, dass** der mindestens eine Graben (10) dem Leistungsbereich benachbart und in direktem Kontakt mit dem P/N-Übergang angeordnet ist sowie eine Tiefe aufweist, die gleich oder größer ist als die Tiefe des P/N-Übergangs, wobei der mindestens eine Graben (10) ausgehend von einer Mehrzahl von kleinen Gräben (8), die in dem Halbleitersubstrat (1) mit vorbestimmten Längen gleich der Tiefe des mindestens einen Grabens (10) realisiert sind und von einer Mehrzahl von entsprechenden Wänden (9) aus Halbleitermaterial mit vorbestimmten Breiten begrenzt sind, durch Oxidieren des Halbleitermaterials mittels eines Wärmeprozesses gebildet ist, um die Wände (9) zu oxidieren und den mindestens einen Graben (10) zu erzeugen, der in einer Sperr-Vorspannungssituation wirksam ist, um dafür zu sorgen, dass sich Äquipotentiallinien des elektrischen Feldes im Inneren des Bauelements innerhalb des mindestens einen Grabens (10) zusammendrängen.

2. Elektronisches Bauelement nach Anspruch 1,
**dadurch gekennzeichnet, dass** die kleinen Gräben (8) gleichmäßig voneinander beabstandet und parallel zueinander sind.

3. Elektronisches Bauelement nach Anspruch 1,
**dadurch gekennzeichnet, dass** mindestens eine epitaktische Halbleiterschicht (2) des ersten Leitfähigkeitstyps auf das Halbleitersubstrat (1) aufgebracht ist und dass der mindestens eine Graben (10) ausgehend von der oberen Oberfläche des Bauelements tiefer ist als die epitaktische Schicht (2).

4. Elektronisches Bauelement nach Anspruch 1,
wobei es sich bei dem Dielektrikum in dem Graben (10) um Siliziumoxid handelt.

5. Elektronisches Bauelement nach Anspruch 1,
**dadurch gekennzeichnet, dass** es eine Metallisierungsschicht (16) aufweist, die die P-leitende Seite des P/N-Übergangs, jedoch nicht den mindestens einen Graben (10) bedeckt.

6. Elektronisches Bauelement nach Anspruch 1,
**dadurch gekennzeichnet, dass** es eine Metallisierungsschicht (17) aufweist, die die N-leitende Seite des P/N-Übergangs, jedoch nicht den mindestens einen Graben (10) bedeckt.

7. Elektronisches Bauelement nach Anspruch 1,
**dadurch gekennzeichnet, dass** das Verhältnis der Längen der kleinen Gräben (8) zu den Breiten der Wände (9) derart ist, dass die kleinen Gräben (8) aus dem oxidierenden Wärmeprozess vollständig mit Oxid gefüllt hervorgehen.

8. Verfahren zum Herstellen eines in ein Halbleitersubstrat (1) monolithisch integrierten elektronischen Leistungsbauelements mit mindestens einem Leistungsbereich, in dem wiederum mindestens ein P/N-Übergang vorgesehen ist, der einen ersten Halbleiterbereich (3) eines ersten Leitfähigkeitstyps aufweist, der sich von einer oberen Oberfläche des Bauelements in das Halbleitersubstrat (1) hinein erstreckt und in einen zweiten Halbleiterbereich (2) eines zweiten Leitfähigkeitstyps entgegengesetzt zu dem ersten Leitfähigkeitstyp eindiffundiert ist,
**dadurch gekennzeichnet, dass** mindestens ein mit dielektrischem Material gefüllter Graben, (10), der als Randschutzstruktur des P/N-Übergangs vorgesehen wird, durch folgende Schritte gebildet wird:
Bilden einer Mehrzahl von kleinen Gräben (8) in dem Halbleitersubstrat (1), die vorbestimmte Längen aufweisen, die gleich oder größer sind als die Tiefe des P/N-Übergangs, und die von einer Mehrzahl von entsprechenden Wänden (9) aus Halbleitermaterial mit vorbestimmten Breiten begrenzt sind;
Oxidieren des Halbleitermaterials mittels eines Wärmeprozesses, um die Wände (9) zu oxidieren und den mindestens einen Graben (10) dem Leistungsbereich benachbart und in direktem Kontakt mit dem P/N-Übergang zu erzeugen, wobei der mindestens eine Graben (10) in einer Sperr-Vorspannungssituation wirksam ist, um dafür zu sorgen, dass sich Äquipotentiallinien des elektrischen Feldes im Inneren des Bauelements innerhalb des mindestens einen Grabens (10) zusammendrängen.

9. Verfahren zum Herstellen eines elektronischen Bauelements nach Anspruch 7,
**dadurch gekennzeichnet, dass** der Schritt zum Bilden einer Mehrzahl von kleinen Gräben (8) zum Bilden von kleinen Gräben (8) führt, die gleichmäßig voneinander beabstandet und parallel zueinander sind.

10. Verfahren zum Herstellen eines elektronischen Bauelements nach Anspruch 8,
**dadurch gekennzeichnet, dass** das Verhältnis der Längen der kleinen Gräben (8) zu den Breiten der Wände (9) derart ist, dass die kleinen Gräben (8) aus dem oxidierenden Wärmeprozess vollständig mit Oxid gefüllt hervorgehen.

11. Verfahren zum Herstellen eines elektronischen Bauelements nach Anspruch 8,
**dadurch gekennzeichnet, dass** es ferner einen Schritt zum Aufbringen einer dielektrischen Schicht mit Planarisierungseigenschaften aufweist, um Bereiche der kleinen Gräben (8) auszufülien.

12. Verfahren zum Herstellen eines elektronischen Bauteils nach Anspruch 8,
**dadurch gekennzeichnet, dass** es ferner einen Planarisierungsprozess beinhaltet.

13. Verfahren zum Herstellen eines elektronischen Bauelements nach Anspruch 8,
**dadurch gekennzeichnet, dass** der Schritt zum Bilden der Mehrzahl von kleinen Gräben (8) den zweiten Halbleiterbereich (3) unterbricht, so dass ein Übergang vom so genannten Mesa-Typ geschaffen wird.

## Revendications

1. Dispositif électronique de puissance intégré de manière monolithique dans un substrat à semiconducteur (1) comprenant au moins une région de puissance, comportant elle-même au moins une jonction P/N prévue dans celle-ci, qui comprend une première région de semiconducteur (3) présentant un premier type de conductivité s'étendant dans ledit substrat à semiconducteur (1) depuis une surface supérieure du dispositif et étant diffusée dans une second région de semiconducteur (2) présentant un second type de conductivité qui est opposé par rapport au premier type de conductivité, ledit dispositif comprenant en outre au moins une structure de protection de bord d'épaisseur importante et une taille plane limitée incorporant au moins une tranchée (10) remplie d'un matériau diélectrique, **caractérisé en ce que** ladite au moins une tranchée (10) est placée de manière adjacente à ladite région de puissance et en contact direct avec ladite jonction P/N et elle présente une profondeur supérieure ou égale à la profondeur de ladite jonction P/N, ladite au moins une tranchée (10) étant formée, en commençant à partir d'une pluralité de petites tranchées (8) réalisées dans ledit substrat à semiconducteur (1) avec des longueurs prédéterminées égales à ladite profondeur de ladite au moins une tranchée (10) et limitées par une pluralité de parois correspondantes (9) d'un matériau semiconducteur présentant des largeurs prédéterminées, par oxydation dudit matériau semiconducteur au moyen d'un traitement thermique afin d'oxyder lesdites paroi (9) et produire ladite au moins une tranchée (10) qui est efficace, dans une situation de polarisation inverse, pour amener des lignes équipotentielles du champ électrique à l'intérieur dudit dispositif à se rassembler à l'intérieur de ladite au moins une tranchée (10).

2. Dispositif électronique selon la revendication 1, **caractérisé en ce que** de petites tranchées (8) sont espacées de manière équidistante et parallèles les unes aux autres.

3. Dispositif électronique selon la revendication 1, **caractérisé en ce qu'**au moins une couche de semiconducteur épitaxiale (2) présentant ledit premier type de conductivité est déposée sur le substrat à semiconducteur (1), et **en ce que** ladite au moins une tranchée (10) s'étend plus profondément que la couche épitaxiale (2) à partir de la surface supérieure du dispositif.

4. Dispositif électronique selon la revendication 1, dans lequel ledit diélectrique dans ladite tranchée (10) est de l'oxyde de silicium.

5. Dispositif électronique selon la revendication 1, **caractérisé en ce qu'**il comprend une couche de métallisation (16) recouvrant le côté P de la jonction P/N mais non pas ladite au moins une tranchée (10).

6. Dispositif électronique selon la revendication 1, **caractérisé en ce que en ce qu'**il comprend une couche de métallisation (17) recouvrant le côté N de la jonction P/N mais non pas ladite au moins une tranchée (10).

7. Dispositif électronique selon la revendication 1, **caractérisé en ce que** le rapport desdites longueurs desdites petites tranchées (8) sur lesdites largeurs desdites parois (9) est tel que lesdites petites tranchées (8) sortent dudit traitement thermique d'oxydation complètement remplies d'oxyde.

8. Procédé de fabrication d'un dispositif électronique de puissance intégré de manière monolithique dans un substrat à semiconducteur (1), comprenant au moins une région de puissance, comportant elle-même au moins une jonction P/N prévue dans celle-ci, laquelle comprend une première région de semiconducteur (3) présentant un premier type de conductivité s'étendant jusque dans ledit substrat de semiconducteur (1) depuis une surface de dispositif supérieure et étant diffusée dans une seconde région de semiconducteur (2) présentant un second type de conductivité qui est opposé par rapport au premier type de conductivité, **caractérisé en ce qu'**au moins une tranchée (10) remplie d'un matériau diélectrique, prévu en tant que structure de protection de bord de ladite jonction P/N, est obtenue par les étapes suivantes consistant à :
former une pluralité de petites tranchées (8) dans ledit substrat à semiconducteur (1) qui présentent des longueurs prédéterminées supérieures ou égales à la profondeur de ladite jonction P/N et sont limitées par une pluralité de parois correspondantes (9) du matériau semiconducteur ayant des largeurs prédéterminées,
oxyder ledit matériau de semiconducteur au moyen d'un traitement thermique afin d'oxyder lesdites parois (9) et de produire ladite au moins une tranchée (10) adjacente à ladite région de puissance et en contact direct avec ladite jonction P/N, ladite au moins une tranchée (10) étant efficace, dans une situation de polarisation inverse, pour amener des lignes équipotentielles du champ électrique à l'intérieur dudit dispositif à se rassembler à l'intérieur de ladite au moins une tranchée (10).

9. Procédé de fabrication d'un dispositif électronique selon la revendication 7, **caractérisé en ce que** ladite étape de formation d'une pluralité de petites tranchées (8) forme des petites tranchées (8) qui sont espacées de manière équidistante et parallèles les unes aux autres.

10. Procédé de fabrication d'un dispositif électronique selon la revendication 8, **caractérisé en ce que** le rapport desdites longueurs desdites petites tranchées (8) sur lesdites largeurs desdites parois (9) est tel que lesdites petites tranchées (8) sortent dudit traitement thermique d'oxydation complètement remplies d'oxyde.

11. Procédé de fabrication d'un dispositif électronique selon la revendication 8, **caractérisé en ce qu'**il comprend en outre une étape consistant à déposer une couche de diélectrique présentant des propriétés pour rendre plan afin de remplir des régions desdites petites tranchées (8).

12. Procédé de fabrication d'un dispositif électronique selon la revendication 8, **caractérisé en ce qu'**il comprend en outre un traitement pour rendre plan.

13. Procédé de fabrication d'un dispositif électronique selon la revendication 8, **caractérisé en ce que** ladite étape consistant à former ladite pluralité de petites tranchées (8) interrompt ladite seconde région de semiconducteur (3) en procurant ainsi une jonction du type appelé mésa.
